# DEMANDE DE BREVET EUROPEEN

(11) **EP 1 528 391 A1**
(43) Date de publication de la demande: **04.05.2005**
(21) Numéro de dépôt: 04292258.3
(22) Date de dépôt: 21.09.2004
(51) Int. Cl.: G01N 21/956, G01R 31/309, G01R 31/28, G06T 7/00

(54) **Procédé pour déterminer des modifications apportées à une carte électronique et méthodes de fabrication**

(30) Priorité: 30.10.2003 FR 0312723
(71) Demandeur: AIRBUS FRANCE, 31060 Toulouse (FR)
(72) Inventeur: Alaux, Philippe, 31660 Buzet sur Tarn (FR); Pons, Philippe, 31600 Muret (FR)
(74) Mandataire: Hauer, Bernard

(57) **Abrégé**

- Procédé pour déterminer des modifications apportées à une carte électronique et méthodes de fabrication d'une carte électronique et d'un équipement muni d'une carte électronique.
- Selon l'invention, on détermine un premier schéma (S1) illustrant la carte électronique qui comporte des composants électroniques (CE1, CE2, CE3), des ports (P1, P2), des éléments d'alimentation (A1) et des moyens de connexion (L1 à L7) à un premier moment, on détermine un second schéma illustrant la carte électronique à un second moment, on attribue une classe relative à un changement à chaque entité desdits schémas, on associe un attribut d'identification visuelle à chaque entité, qui est représentatif de sa classe, on construit deux images correspondant aux premier et second schémas en mettant en évidence les attributs d'identification visuelle, et on compare lesdites images pour en déduire les modifications apportées à la carte électronique entre les premier et second moments.

## Description

La présente invention concerne un procédé pour déterminer des modifications apportées à une carte électronique, ainsi que des méthodes de fabrication d'une telle carte électronique et d'un équipement muni d'une telle carte électronique, méthodes de fabrication qui utilisent ce procédé.

On sait qu'une carte électronique comporte des éléments constitutifs tels que des composants électroniques, des ports, des éléments d'alimentation et des moyens de connexion.

De nombreux équipements, tant domestiques qu'industriels, comprennent une ou plusieurs cartes électroniques de ce type. De tels équipements sont généralement fabriqués au cours d'un cycle industriel particulier connu. Au cours de ce cycle industriel, il est fréquent que des modifications doivent être apportées au schéma d'une ou de plusieurs cartes électroniques de l'équipement. Ces modifications peuvent intervenir à plusieurs étapes du cycle industriel, notamment après des tests d'une carte prototype, lors de l'intégration dans l'équipement, après des tests d'un équipement prototype, ou lors d'évolutions de l'équipement en phase de production en série.

Lorsque des modifications doivent être apportées à une carte électronique, il convient de régénérer des données industrielles ou des éléments justificatifs de définition ou de qualification, à partir d'une étape initiale de saisie du schéma illustrant la carte électronique. Le test exhaustif d'une carte électronique, et a fortiori d'un équipement comportant au moins une telle carte, étant une opération longue et complexe, les tests subséquents à une ou des modifications d'une carte électronique ne concernent généralement que les parties modifiées de ladite carte. Aussi, il est nécessaire de savoir déterminer de façon précise les modifications qui ont été apportées à cette carte depuis les tests précédents.

Une solution pour déterminer les modifications apportées à une carte électronique consiste à noter manuellement les modifications au fur et à mesure qu'un opérateur modifie le schéma au moyen d'un logiciel de CAO ("Conception Assistée par Ordinateur"). Toutefois, cette solution présente l'inconvénient d'un risque d'erreurs non négligeable, pouvant notamment être dues à des oublis dudit opérateur.

Une autre solution consiste à comparer visuellement l'ancien schéma et le nouveau schéma une fois celui-ci terminé, et à noter les différences vues par un opérateur. Là encore, le risque d'erreurs ou d'oublis n'est pas négligeable, surtout si le schéma est complexe.

La présente invention a pour objet de remédier à ces inconvénients. Elle concerne un procédé pour déterminer facilement et de façon fiable toute modification qui a été apportée entre un premier moment et un second moment à une carte électronique du type précité.

A cet effet, selon l'invention, ledit procédé est remarquable en ce que :
a) on détermine un premier schéma illustrant ladite carte électronique audit premier moment, ledit premier schéma comportant un ensemble d'entités représentant les éléments constitutifs (de ladite carte électronique) audit premier moment, ledit premier schéma étant présenté sous forme d'un premier tableau ;
b) on détermine un second schéma illustrant ladite carte électronique audit second moment, ledit second schéma comportant un ensemble d'entités représentant lesdits éléments constitutifs audit second moment, ledit second schéma étant présenté sous forme d'un second tableau ;
c) on attribue une classe relative à un changement à chaque entité desdits premier et second schémas ;
d) on associe un attribut d'identification visuelle à chaque entité desdits premier et second schémas, ledit attribut d'identification visuelle étant représentatif de la classe de cette entité ;
e) on construit une première et une seconde images correspondant respectivement auxdits premier et second schémas, dans lesquelles les différentes entités sont représentées en mettant à chaque fois en évidence l'attribut d'identification visuelle associé ; et
f) on compare lesdites première et seconde images pour en déduire le cas échéant les modifications apportées à ladite carte électronique entre lesdits premier et second moments.

Ainsi, grâce à l'invention, on peut identifier facilement de façon visuelle toute modification apportée à la carte électronique en comparant lesdites première et seconde images, ce qui permet de déterminer facilement et de façon fiable toutes les modifications qui ont été faites entre lesdits premier et second moments.

De façon avantageuse, à l'étape c), on attribue l'une des cinq classes suivantes à chaque entité :
- une classe d'entité inchangée ;
- une classe d'entité modifiée ;
- une classe d'entité déplacée ;
- une classe d'entité ajoutée ; et
- une classe d'entité supprimée.

Dans un mode de réalisation préféré, à l'étape c), pour attribuer une classe à chaque entité desdits premier et second tableaux représentant lesdits premier et second schémas :
c1) on considère chaque entité dudit premier tableau :
   - si cette entité n'est pas présente dans ledit second tableau, elle a été supprimée, et on lui attribue ladite classe d'entité supprimée ;
   - sinon :
      - si les propriétés de ladite entité sont différentes dans lesdits premier et second tableaux, elle a été modifiée, et on lui attribue ladite classe d'entité modifiée ; et
      - si les coordonnées de ladite entité sont différentes dans lesdits premier et second tableaux, elle a été déplacée, et on lui attribue ladite classe d'entité déplacée ;
c2) on considère chaque entité dudit second tableau :
   - si cette entité n'est pas présente dans ledit premier tableau, elle a été ajoutée, et on lui attribue ladite classe d'entité ajoutée ; et
c3) toute entité qui n'a pas été modifiée, déplacée, ajoutée ou supprimée, est considérée comme inchangée, et on lui attribue ladite classe d'entité inchangée.

Dans une première variante, à l'étape c2), on considère chaque entité dudit second tableau et on vérifie sa présence dans ledit premier tableau.

Dans une seconde variante, à l'étape c1), on associe à chaque entité présente dans ledit premier tableau un indicateur dans ledit second tableau, et à l'étape c2), on recherche dans ledit second tableau chaque entité à laquelle n'est pas associée à un tel indicateur, et à chacune d'elles on attribue la classe d'entité ajoutée.

En outre, dans un premier mode de réalisation, à l'étape c), on forme un tableau de classe pour chacune desdites classes et, au fur et à mesure que l'on attribue une classe aux entités, on note chaque entité dans le tableau de classe correspondant à sa classe.

Dans un second mode de réalisation, à l'étape c), on ajoute dans chacun desdits premier et second tableaux une colonne supplémentaire correspondant à la classe et, au fur et à mesure que l'on attribue une classe aux entités, on indique pour chaque entité le nom de la classe dans ladite colonne supplémentaire, à la ligne correspondant à cette entité dans ledit (premier ou second) tableau.

De préférence, chaque attribut d'identification visuelle correspond à une couleur particulière.

Par ailleurs, avantageusement :
- à l'étape e), on construit ladite première image de sorte qu'elle comprenne les classes d'entité inchangée, d'entité modifiée, d'entité déplacée et d'entité supprimée, et on construit ladite seconde image de sorte qu'elle comprenne les classes d'entité inchangée, d'entité modifiée, d'entité déplacée et d'entité ajoutée ; et/ou
- à l'étape e), on construit lesdites première et seconde images à l'aide d'un outil de conception assistée par ordinateur ; et/ou
- à l'étape e), on ajoute une indication visuelle particulière sur lesdites première et seconde images, lorsqu'à toutes les entités desdites première et seconde images on a attribué la classe d'entité inchangée ; et/ou
- on forme un tableau récapitulatif comprenant toutes les entités des classes d'entité autres que la classe d'entité inchangée. Dans ce cas, de préférence, on construit une troisième image représentant ledit tableau récapitulatif ; et/ou
- on forme au moins un fichier représentatif des modifications déterminées, qui est susceptible d'être exploité par un outil de conception assistée par ordinateur.

La présente invention concerne également une première méthode de fabrication d'au moins une carte électronique qui comporte des éléments constitutifs comprenant des composants électroniques, des ports, des éléments d'alimentation et des moyens de connexion.

Ladite première méthode, selon laquelle :
A/ on forme un schéma illustrant ladite carte électronique et comportant un ensemble d'entités représentant lesdits éléments constitutifs ;
B/ on place des composants et on crée des pistes sur un circuit électrique pour former une carte, conformément audit schéma ;
C/ on simule le fonctionnement de ladite carte ;
D/ on crée des fichiers de fabrication de ladite carte ;
E/ on fabrique une carte prototype à l'aide desdits fichiers de fabrication ;
F/ on réalise au moins un test de validation de ladite carte prototype ; et
G/ on produit au moins une carte électronique conformément à ladite carte prototype,
est remarquable selon l'invention en ce que, lorsqu'au moins une modification est apportée à ladite carte électronique :
α) on met en oeuvre le procédé précité pour déterminer cette modification ; et
β) on met en oeuvre lesdites étapes B/ à F/ en réalisant des tests uniquement pour les parties de ladite carte électronique qui sont concernées par ladite modification.

La présente invention concerne également une seconde méthode de fabrication d'au moins un équipement muni d'au moins une carte électronique qui comporte des éléments constitutifs tels que des composants électroniques, des ports, des éléments d'alimentation et des moyens de connexion, méthode selon laquelle :
01 / on fabrique au moins une carte électronique ;
02/ on intègre chaque carte électronique ainsi fabriquée dans un équipement de base pour réaliser un équipement prototype ;
03/ on réalise au moins un test sur ledit équipement prototype ;
04/ on réalise la validation dudit équipement prototype à partir dudit test ; et
05/ on produit au moins un équipement conformément audit équipement prototype.

Selon l'invention, ladite seconde méthode est remarquable en ce qu'à l'étape 01/, pour fabriquer au moins une carte électronique, on met en oeuvre la première méthode précitée.

Par ailleurs, la présente invention concerne également une carte électronique et un équipement qui sont fabriqués respectivement à l'aide desdites première et seconde méthodes présentées ci-dessus.

Les figures du dessin annexé feront bien comprendre comment l'invention peut être réalisée. Sur ces figures, des références identiques désignent des éléments semblables.
La figure 1 représente un schéma illustrant une carte électronique.
La figure 2 illustre les étapes successives d'un procédé conforme à l'invention.
Les figures 3 et 4 sont deux images obtenues grâce à l'invention et représentant une carte électronique à deux moments différents.
La figure 5 illustre les étapes successives d'une méthode de fabrication conforme à l'invention d'une carte électronique.
La figure 6 illustre les étapes successives d'une méthode de fabrication conforme à l'invention d'un équipement muni d'une carte électronique.

La présente invention a notamment pour objet un procédé pour déterminer des modifications qui sont apportées à une carte électronique lors de sa fabrication. Une telle carte électronique comporte, de façon usuelle, une plaquette, servant de support et constituée de circuits imprimés, sur lesquels sont soudés des composants.

On sait qu'une carte électronique comporte, en général, comme éléments constitutifs :
- des composants électroniques actifs ou passifs. Un composant électronique est passif lorsqu'il ne nécessite aucun apport extérieur d'énergie (résistance, condensateur, ...) et actif, lorsqu'il a besoin d'un apport extérieur d'énergie (tube électronique, transistor, circuit intégré, ...) ;
- des ports ;
- des éléments d'alimentation (masse, tension, ...) ; et
- des moyens de connexion.

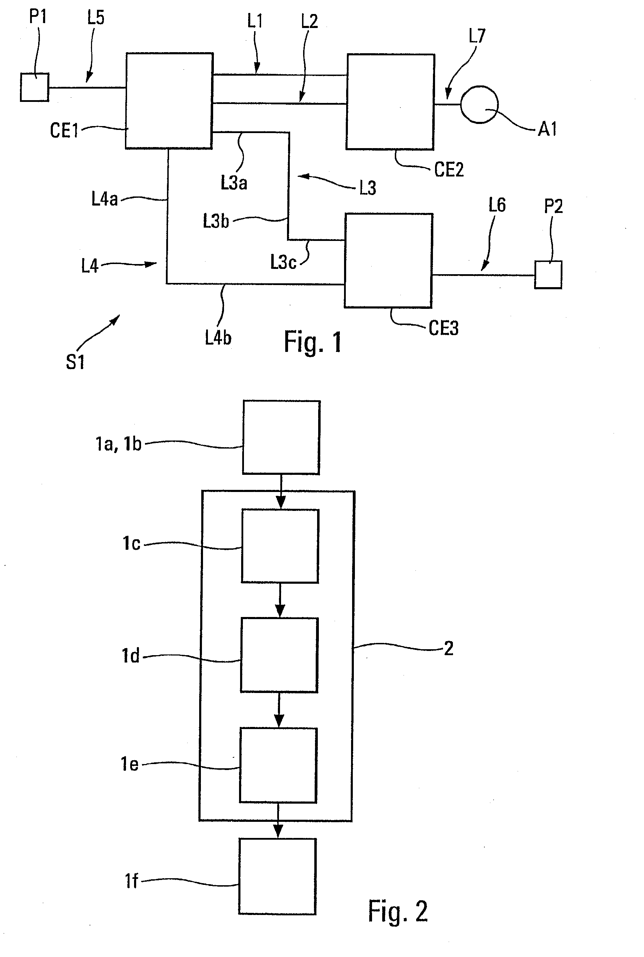

Une telle carte électronique peut être illustrée de façon usuelle par un schéma S1, comme représenté sur la figure 1. Un tel schéma est constitué d'une ou plusieurs feuilles. Chaque feuille comporte un ensemble d'entités E1 à E16 représentant lesdits éléments constitutifs, à savoir :
- des composants électroniques CE1, CE2, CE3 ;
- des ports P1, P2 permettant de relier ensemble deux moyens de connexion ;
- des moyens de connexion L1 à L7. Chaque moyen de connexion L1 à L7 comporte au moins un segment de droite ou lien. Ainsi, les moyens de connexion L1, L2, L5, L6 et L7 ne comportent qu'un seul lien, alors que le moyen de connexion L3 comporte trois liens L3a, L3b et L3c et le moyen de connexion L4 comporte deux liens L4a et L4b ; et
- des éléments d'alimentation A1.

De plus, chacune desdites entités E1 à E16 peut être caractérisée par ses coordonnées sur le schéma S1, à savoir :
- par les coordonnées des deux points d'extrémité dans le cas d'un lien d'un moyen de connexion ; et
- par les coordonnées d'un point de référence pour toute entité autre qu'un moyen de connexion.

Le schéma d'une carte électronique peut donc être représenté sous forme d'un tableau, comme représenté ci-après pour ledit schéma S1 de la figure 1.

| Entités | Propriétés | Coordonnées |
|---|---|---|
| E1 | CE1 | x1, y1 |
| E2 | CE2 | x2, y2 |
| E3 | CE3 | x3, y3 |
| E4 | P1 | x4, y4 |
| E5 | P2 | x5, y5 |
| E6 | L1 | x6a, y6a ; x6b, y6b |
| E7 | L2 | x7a, y7a ; x7b, y7b |
| E8 | L3a | x8a, y8a ; x8b, y8b |
| E9 | L3b | x8b, y8b ; x9b, y9b |
| E10 | L3c | x9b, y9b ; x10b, y10b |
| E11 | L4a | x11a, y11a ; x11b, y11b |
| E12 | L4b | x11b, y11b ; x12b, y12b |
| E13 | L5 | x13a, y13a ; x13b, y13b |
| E14 | L6 | x14a, y14a ; x14b, y14b |
| E15 | L7 | x15a, y15a ; x15b, y15b |
| E16 | A1 | x16,y16 |

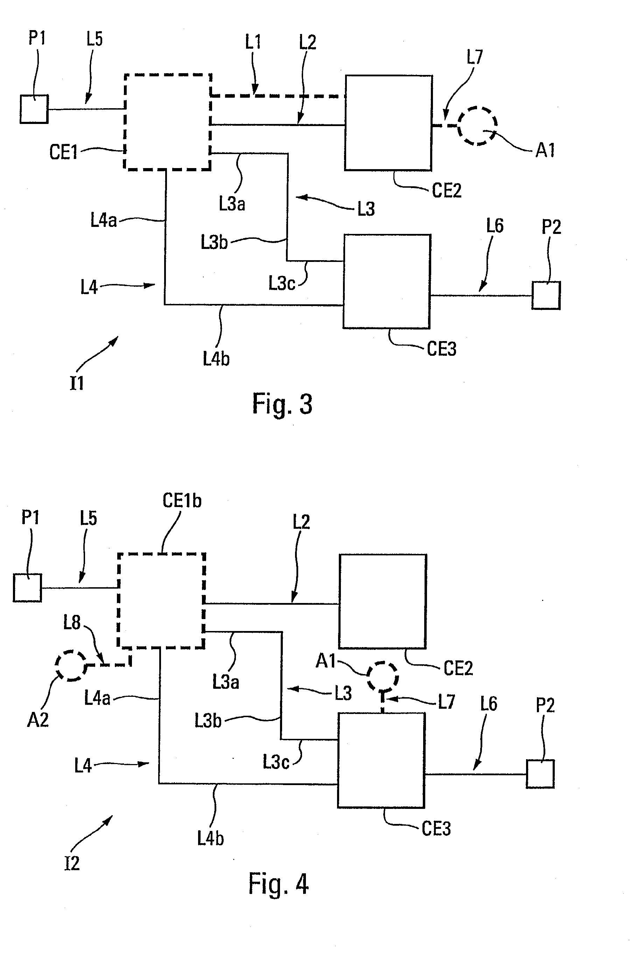

Selon l'invention, pour déterminer des modifications qui ont été apportées à une telle carte électronique entre un premier moment M1 et un second moment M2 (ultérieur audit premier moment M1), on met en oeuvre un procédé comprenant une suite d'étapes successives 1a à 1f, comme illustré sur la figure 2, à savoir les étapes :
1a) pour déterminer un premier schéma S1 illustrant ladite carte électronique audit premier moment M1, ledit premier schéma comportant un ensemble d'entités E1 à E16 représentant lesdits éléments constitutifs audit premier moment M1, ledit premier schéma étant présenté sous forme d'un premier tableau T1 précisé ci-dessous ;
1b) pour déterminer un second schéma illustrant ladite carte électronique audit second moment M2, ledit second schéma comportant un ensemble d'entités E1 à E5 et E7 à E18 représentant lesdits éléments constitutifs audit second moment M2, ledit second schéma étant présenté sous forme d'un second tableau T2 précisé ci-dessous ;
1c) pour attribuer une classe relative à un changement à chaque entité desdits premier et second tableaux T1 et T2 ;
1d) pour associer un attribut d'identification visuelle à chaque entité desdits premier et second tableaux T1 et T2, ledit attribut d'identification visuelle étant représentatif de la classe de cette entité ;
1e) pour construire une première et une seconde images I1 et I2 représentées respectivement sur les figures 3 et 4 et correspondant respectivement auxdits premier et second schémas, dans lesquelles les différentes entités sont représentées en mettant à chaque fois en évidence l'attribut d'identification visuelle associé ; et
1f) pour comparer (visuellement) lesdites première et seconde images I1 et I2 afin d'en déduire le cas échéant les modifications apportées à ladite carte électronique entre lesdits premier et second moments M1 et M2.

**Tableau T1**

| Entités | Propriétés | Coordonnées | Classe |
|---|---|---|---|
| E1 | CE1 | x1, y1 | M |
| E2 | CE2 | x2, y2 | I |
| E3 | CE3 | x3, y3 | I |
| E4 | P1 | x4, y4 | I |
| E5 | P2 | x5, y5 | I |
| E6 | L1 | x6a, y6a ; x6b, y6b | S |
| E7 | L2 | x7a, y7a ; x7b, y7b | I |
| E8 | L3a | x8a, y8a ; x8b, y8b | I |
| E9 | L3b | x8b, y8b ; x9b, y9b | I |
| E10 | L3c | x9b, y9b ; x10b, y10b | I |
| E11 | L4a | x11a, y11a ; x11b, y11b | I |
| E12 | L4b | x11b, y11b ; x12b, y12b | I |
| E13 | L5 | x13a, y13a ; x13b, y13b | I |
| E14 | L6 | x14a, y14a ; x14b, y14b | I |
| E15 | L7 | x15a, y15a ; x15b, y15b | D |
| E16 | A1 | x16, y16 | D |

**Tableau T2**

| Entités | Propriétés | Coordonnées | Classe |
|---|---|---|---|
| E1 | CE1b | x1, y1 | M |
| E2 | CE2 | x2, y2 | I |
| E3 | CE3 | x3, y3 | I |
| E4 | P1 | x4, y4 | I |
| E5 | P2 | x5, y5 | I |
| E7 | L2 | x7a, y7a ; x7b, y7b | 1 |
| E8 | L3a | x8a, y8a ; x8b, y8b | I |
| E9 | L3b | x8b, y8b ; x9b, y9b | I |
| E10 | L3c | x9b, y9b ; x10b, y10b | I |
| E11 | L4a | x11a, y11a ; x11b, y11b | I |
| E12 | L4b | x11b, y11b ; x12b, y12b | I |
| E13 | L5 | x13a, y13a ; x13b, y13b | I |
| E14 | L6 | x14a, y14a ; x14b, y14b | I |
| E15 | L7 | x15c, y15c ; x15d, y15d | D |
| E16 | A1 | x16a, y16a | D |
| E17 | A2 | x17, y17 | A |
| E18 | L8 | x18a, y18a ; x18b, y18b | A |

Dans un premier mode de réalisation, et comme précisé sur les tableaux T1 et T2 ci-dessus, à l'étape 1c), on ajoute dans chacun desdits tableaux T1 et T2 une colonne supplémentaire correspondant à la classe et, au fur et à mesure que l'on attribue une classe aux entités E1 à E18, on indique pour chaque entité le nom de la classe dans ladite colonne supplémentaire, à la ligne correspondant à cette entité dans ledit tableau T1 ou T2.

Plus précisément, on attribue l'une des cinq classes suivantes à chaque entité E1 à E18 :
- une classe I d'entité inchangée ;
- une classe M d'entité modifiée ;
- une classe D d'entité déplacée ;
- une classe A d'entité ajoutée ; et
- une classe S d'entité supprimée.

Dans un second mode de réalisation, à l'étape 1c, on forme un tableau de classe pour chacune desdites classes I, M, D, A et S et, au fur et à mesure que l'on attribue une classe auxdites entités E1 à E18, on note chaque entité dans le tableau de classe correspondant à sa classe.

Selon l'invention, à ladite étape 1c, pour attribuer une classe à chaque entité E1 à E18 desdits tableaux T1 et T2 représentant lesdits premier et second schémas :
c1) on considère chaque entité dudit tableau T1 :
   - si cette entité n'est pas présente dans ledit tableau T2, comme l'entité E6 par exemple, elle a été supprimée, et on lui attribue ladite classe S d'entité supprimée ;
   - sinon :
      - si les propriétés de ladite entité sont différentes dans lesdits tableaux T1 et T2, comme pour l'entité E1 par exemple, elle a été modifiée, et on lui attribue ladite classe M d'entité modifiée ; et
      - si les coordonnées de ladite entité sont différentes dans les tableaux T1 et T2, comme pour les entités E15 et E16 par exemple, elle a été déplacée, et on lui attribue ladite classe D d'entité déplacée ;
c2) puis, on considère chaque entité dudit tableau T2 :
   - si cette entité n'est pas présente dans ledit tableau T1, comme les entités E17 et E18 par exemple, elle a été ajoutée, et on lui attribue ladite classe A d'entité ajoutée ; et
c3) toute entité qui n'a pas été modifiée, déplacée, ajoutée ou supprimée, est considérée comme inchangée, comme les entités E2 et E3 par exemple, et on lui attribue ladite classe I d'entité inchangée.

Concernant ladite classe A d'entité ajoutée :
- dans une première variante, à l'étape c2, on considère chaque entité dudit tableau T2 et on vérifie sa présence dans ledit tableau T1 ; et
- dans une seconde variante, à l'étape c1, on associe à chaque entité présente dans ledit tableau T1 un indicateur représentatif de cette présence dans ledit tableau T2, et à l'étape c2, on recherche dans ledit tableau T2 chaque entité à laquelle n'est pas associée à un tel indicateur, et à chacune d'elles on attribue la classe A d'entité ajoutée.

Dans un mode de réalisation préféré, l'attribut d'identification visuelle associé à chaque entité E1 à E18 correspond à une couleur, avec laquelle on représente cette entité sur l'image I1, I2 correspondante. Par exemple, les entités inchangées peuvent être représentées en noir, les entités modifiées en bleu, les entités déplacées en jaune, les entités supprimées en rouge et les entités ajoutées en vert.

De façon avantageuse, lesdites première et seconde images I1 et I2 sont construites au moyen d'un logiciel de "CAO" (Conception Assistée par Ordinateur) utilisé pour la saisie des schémas considérés. La conception assistée par ordinateur comprend, de façon générale, l'ensemble des techniques informatiques servant à la création de données décrivant un objet à concevoir, à la manipulation de ces données en vue d'aboutir à une forme achevée de conception et à la génération d'informations nécessaires à la fabrication de cet objet. Pour cela, à l'étape 1d, on modifie les fichiers correspondant à ces schémas de façon à attribuer une couleur à chaque entité selon la classe à laquelle elle appartient. A l'étape 1e, on affiche alors (au moyen dudit logiciel de CAO) sur un moyen d'affichage approprié associé les fichiers ainsi modifiés. De préférence, afin de conserver intacts les fichiers correspondant aux schémas, on effectue ces modifications sur des copies desdits fichiers.

Dans un mode de réalisation préféré, lorsque toutes les entités des tableaux T1 et T2 sont de classe I d'entité inchangée, à l'étape 1e, on ajoute une indication visuelle dans lesdites images I1 et I2 pour signaler que les deux schémas comparés sont identiques. Par exemple, une mention "INCHANGE" peut être affichée en gros caractères en arrière plan de chacune desdites images I1 et I2.

Dans un mode de réalisation particulier, on forme un tableau récapitulatif comprenant toutes les entités des classes M, D, A, S autres que la classe I d'entité inchangée. Dans ce cas, on construit une troisième image (non représentée) correspondant audit tableau récapitulatif.

L'invention présente donc l'avantage de permettre facilement une identification visuelle des modifications apportées à une carte électronique, par la comparaison visuelle desdites images I1 et I2. Sur les figures 3 et 4, on a mis en évidence les modifications apportées par des traits interrompus renforcés, dans un but de simplification du dessin. En pratique, cette mise en évidence est réalisée de préférence par un jeu de couleurs variées, comme indiqué précédemment.

De plus, on construit un (ou des) fichier(s) représentatif(s) des modifications apportées à la carte électronique, ces fichiers étant aptes à être exploités par des outils de CAO lors d'étapes d'un cycle industriel (ou méthode) de fabrication précisé ci-dessous, de façon à déterminer les tests devant être réalisés de façon subséquente auxdites modifications.

On notera que les étapes 1c à 1e peuvent être regroupées en une seule étape 2 qui peut être mise en oeuvre de façon automatique par un logiciel approprié, créé spécialement à cet effet.

Le procédé précité conforme à l'invention a été décrit dans le cas d'une feuille ("sheet" en anglais) d'un schéma. Bien évidemment, il s'applique de façon identique à chaque feuille d'un schéma comportant plusieurs feuilles et, dans ce cas, le(s) fichier(s) mentionné(s) précédemment peu(ven)t concerner de façon synthétique l'ensemble des feuilles du schéma.

Le procédé conforme à la présente invention peut être utilisé pour comparer deux schémas d'une carte électronique correspondant à des versions consécutives d'un même schéma (par exemple version N et version N + 1). Toutefois, cette utilisation ne doit pas être envisagée de façon limitative, et ledit procédé peut aussi être utilisé pour comparer des schémas correspondant à des versions non consécutives d'un même schéma (par exemple version N et version N + k, k>1).

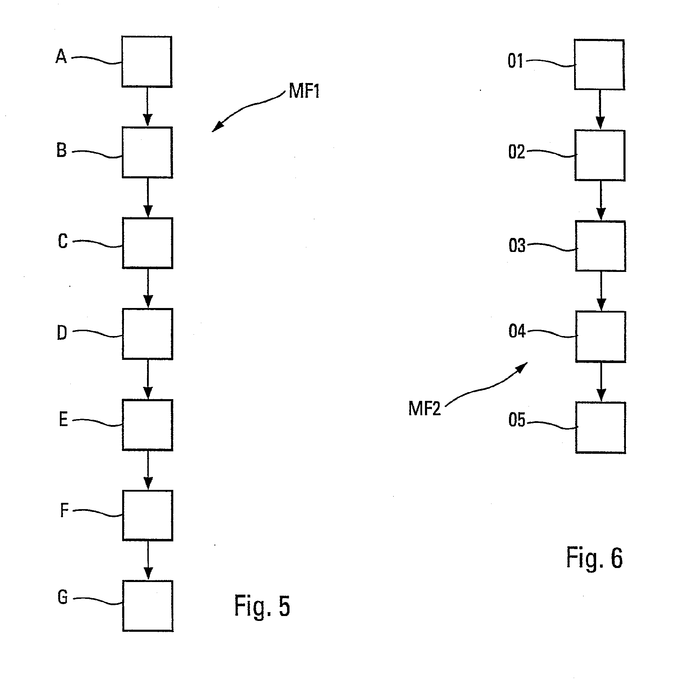

La présente invention concerne également une méthode MF1 de fabrication d'au moins une carte électronique du type précité. Cette méthode MF1 comporte des étapes A à G, représentées sur la figure 5 et consistant :
A/ à former un schéma illustrant ladite carte électronique et comportant un ensemble d'entités E1 à E16 représentant les éléments constitutifs de ladite carte électronique ;
B/ à placer des composants et créer des pistes sur un circuit électrique pour former une première carte, conformément audit schéma ;
C/ à simuler le fonctionnement de ladite première carte ;
D/ à créer des fichiers de fabrication de ladite première carte ;
E/ à fabriquer à l'aide desdits fichiers de fabrication une carte prototype c'est-à-dire un premier exemplaire qui est construit industriellement et qui est destiné à des essais en vue de la production en série ;
F/ à réaliser au moins un test de validation de ladite carte prototype ; et
G/ à produire au moins une carte électronique conformément à ladite carte prototype. Généralement, une telle production est bien entendu une production en série.

Selon l'invention, lorsqu'au moins une modification est apportée à ladite carte électronique lors de sa fabrication :
α) on met en oeuvre le procédé précité (étapes 1a à 1f), pour déterminer cette modification ; et
β) on met en oeuvre lesdites étapes B/ à F/ en réalisant des tests uniquement pour les parties de ladite carte électronique qui sont concernées par la (ou les) modification(s) ainsi déterminée(s).

La présente invention concerne également une méthode MF2 de fabrication d'au moins un équipement muni d'au moins une carte électronique du type précité. Cette méthode MF2 comporte des étapes 01 à 05, représentées sur la figure 6 et consistant :
01 / à fabriquer au moins une carte électronique selon ladite méthode MF1 présentée ci-dessus ;
02/ à intégrer chaque carte électronique ainsi fabriquée dans un équipement de base pour réaliser un équipement prototype ;
03/ à réaliser au moins un test sur ledit équipement prototype ;
04/ à réaliser la validation dudit équipement prototype à partir dudit test ; et
05/ à produire en série des équipements conformément audit équipement prototype.

## Revendications

1. Procédé pour déterminer des modifications apportées à une carte électronique comportant des éléments constitutifs comprenant des composants électroniques (CE1, CE2, CE3), des ports (P1, P2), des éléments d'alimentation (A1, A2) et des moyens de connexion (L1 à L8), entre un premier moment et un second moment ultérieur,
**caractérisé en ce que** :
a) on détermine un premier schéma (S1) illustrant ladite carte électronique audit premier moment, ledit premier schéma comportant un ensemble d'entités représentant lesdits éléments constitutifs audit premier moment, ledit premier schéma étant présenté sous forme d'un premier tableau ;
b) on détermine un second schéma illustrant ladite carte électronique audit second moment, ledit second schéma comportant un ensemble d'entités représentant lesdits éléments constitutifs audit second moment, ledit second schéma étant présenté sous forme d'un second tableau ;
c) on attribue une classe relative à un changement à chaque entité desdits premier et second schémas ;
d) on associe un attribut d'identification visuelle à chaque entité desdits premier et second schémas, ledit attribut d'identification visuelle étant représentatif de la classe de cette entité ;
e) on construit une première et une seconde images (I1, I2) correspondant respectivement auxdits premier et second schémas, dans lesquelles les différentes entités sont représentées en mettant à chaque fois en évidence l'attribut d'identification visuelle associé ; et
f) on compare lesdites première et seconde images (I1, I2) pour en déduire le cas échéant les modifications apportées à ladite carte électronique entre lesdits premier et second moments.

2. Procédé selon la revendication 1,
**caractérisé en ce qu'**à l'étape c), on attribue l'une des cinq classes suivantes à chaque entité :
- une classe d'entité inchangée ;
- une classe d'entité modifiée ;
- une classe d'entité déplacée ;
- une classe d'entité ajoutée ; et
- une classe d'entité supprimée.

3. Procédé selon la revendication 2,
**caractérisé en ce qu'**à l'étape c), pour attribuer une classe à chaque entité desdits premier et second tableaux représentant lesdits premier et second schémas :
c1 ) on considère chaque entité dudit premier tableau :
- si cette entité n'est pas présente dans ledit second tableau, elle a été supprimée, et on lui attribue ladite classe d'entité supprimée ;
- sinon :
• si les propriétés de ladite entité sont différentes dans lesdits premier et second tableaux, elle a été modifiée, et on lui attribue ladite classe d'entité modifiée ; et
• si les coordonnées de ladite entité sont différentes dans lesdits premier et second tableaux, elle a été déplacée, et on lui attribue ladite classe d'entité déplacée ;
c2) on considère chaque entité dudit second tableau :
- si cette entité n'est pas présente dans ledit premier tableau, elle a été ajoutée, et on lui attribue ladite classe d'entité ajoutée ; et
c3) toute entité qui n'a pas été modifiée, déplacée, ajoutée ou supprimée, est considérée comme inchangée, et on lui attribue ladite classe d'entité inchangée.

4. Procédé selon la revendication 3,
**caractérisé en ce qu'**à l'étape c2), on considère chaque entité dudit second tableau et on vérifie sa présence dans ledit premier tableau.

5. Procédé selon la revendication 3,
**caractérisé en ce qu'**à l'étape c1), on associe à chaque entité présente dans ledit premier tableau un indicateur dans ledit second tableau, et à l'étape c2), on recherche dans ledit second tableau chaque entité à laquelle n'est pas associée à un tel indicateur, et à chacune d'elles on attribue la classe d'entité ajoutée.

6. Procédé selon l'une quelconque des revendications précédentes 1 à 5,
**caractérisé en ce qu'**à l'étape c), on forme un tableau de classe pour chacune desdites classes et, au fur et à mesure que l'on attribue une classe aux entités, on note chaque entité dans le tableau de classe correspondant à sa classe.

7. Procédé selon l'une quelconque des revendications précédentes 1 à 5,
**caractérisé en ce qu'**à l'étape c), on ajoute dans chacun desdits premier et second tableaux une colonne supplémentaire correspondant à la classe et, au fur et à mesure que l'on attribue une classe aux entités, on indique pour chaque entité le nom de la classe dans ladite colonne supplémentaire, à la ligne correspondant à cette entité dans ledit tableau.

8. Procédé selon l'une quelconque des revendications précédentes,
**caractérisé en ce que** chaque attribut d'identification visuelle correspond à une couleur particulière.

9. Procédé selon l'une quelconque des revendications précédentes,
**caractérisé en ce qu'**à l'étape e), on construit ladite première image (I1) de sorte qu'elle comprenne les classes d'entité inchangée, d'entité modifiée, d'entité déplacée et d'entité supprimée, et on construit ladite seconde image (I2) de sorte qu'elle comprenne les classes d'entité inchangée, d'entité modifiée, d'entité déplacée et d'entité ajoutée.

10. Procédé selon l'une quelconque des revendications précédentes,
**caractérisé en ce qu'**à l'étape e), on construit lesdites première et seconde images (I1 , I2) à l'aide d'un outil de conception assistée par ordinateur.

11. Procédé selon l'une quelconque des revendications précédentes,
**caractérisé en ce qu'**à l'étape e), on ajoute une indication visuelle particulière sur lesdites première et seconde images (I1 , I2), lorsqu'à toutes les entités desdites première et seconde images (I1, I2) on a attribué la classe d'entité inchangée.

12. Procédé selon l'une quelconque des revendications précédentes,
**caractérisé en ce que** l'on forme un tableau récapitulatif comprenant toutes les entités des classes d'entité autres qu'une classe d'entité inchangée.

13. Procédé selon la revendication 12,
**caractérisé en ce que** l'on construit une troisième image représentant ledit tableau récapitulatif.

14. Procédé selon l'une quelconque des revendications précédentes,
**caractérisé en ce que** l'on forme au moins un fichier représentatif des modifications déterminées, qui est susceptible d'être exploité par un outil de conception assistée par ordinateur.

15. Méthode de fabrication d'au moins une carte électronique comportant des éléments constitutifs comprenant des composants électroniques (CE1, CE2, CE3), des ports (P1, P2), des éléments d'alimentation (A1, A2) et des moyens de connexion (L1 à L8), méthode (MF1) selon laquelle :
A/ on forme un schéma (S1) illustrant ladite carte électronique et comportant un ensemble d'entités représentant lesdits éléments constitutifs ;
B/ on place des composants et on crée des pistes sur un circuit électrique pour former une carte, conformément audit schéma ;
C/ on simule le fonctionnement de ladite carte ;
D/ on crée des fichiers de fabrication de ladite carte ;
E/ on fabrique une carte prototype à l'aide desdits fichiers de fabrication ;
F/ on réalise au moins un test de validation de ladite carte prototype ; et
G/ on produit au moins une carte électronique conformément à ladite carte prototype,
**caractérisée en ce que**, lorsqu'au moins une modification est apportée à ladite carte électronique :
α) on met en oeuvre le procédé spécifié sous l'une quelconque des revendications 1 à 14, pour déterminer cette modification ; et
β) on met en oeuvre lesdites étapes B/ à F/ en réalisant des tests uniquement pour les parties de ladite carte électronique qui sont concernées par ladite modification.

16. Carte électronique comportant des éléments constitutifs comprenant des composants électroniques (CE1, CE2, CE3), des ports (P1, P2), des éléments d'alimentation (A1, A2) et des moyens de connexion (L1 à L8),
**caractérisée en ce qu'**elle est fabriquée par la mise en oeuvre de la méthode de fabrication (MF1) spécifiée sous la revendication 15.

17. Méthode de fabrication d'au moins un équipement muni d'au moins une carte électronique qui comporte des éléments constitutifs comprenant des composants électroniques (CE1, CE2, CE3), des ports (P1, P2), des éléments d'alimentation (A1, A2) et des moyens de connexion (L1 à L8), méthode (MF2) selon laquelle :
01 / on fabrique au moins une carte électronique ;
02/ on intègre chaque carte électronique ainsi fabriquée dans un équipement de base pour réaliser un équipement prototype ;
03/ on réalise au moins un test sur ledit équipement prototype ;
04/ on réalise la validation dudit équipement prototype à partir dudit test ; et
05/ on produit au moins un équipement conformément audit équipement prototype,
**caractérisée en ce qu'**à l'étape 01/, pour fabriquer au moins une carte électronique, on met en oeuvre la méthode de fabrication (MF1) spécifiée sous la revendication 15.

18. Equipement muni d'au moins une carte électronique qui comporte des éléments constitutifs comprenant des composants électroniques (CE1, CE2, CE3), des ports (P1, P2), des éléments d'alimentation (P1, P2) et des moyens de connexion (L1 à L8),
**caractérisé en ce qu'**il est fabriqué par la mise en oeuvre de la méthode de fabrication (MF2) spécifiée sous la revendication 17.
